## Europäisches Patentamt

(19) **European Patent Office**

**Office européen des brevets**

(11) Numéro de publication: **0 046 121**

**A2**

(12) # DEMANDE DE BREVET EUROPEEN

(21) Numéro de dépôt: **81401283.7**

(22) Date de dépôt: **10.08.81**

(51) Int. Cl.³: **H 03 H 17/02**

(30) Priorité: **12.08.80 FR 8017769**

(43) Date de publication de la demande:
**17.02.82 Bulletin 82/7**

(84) Etats contractants désignés:
**BE DE GB IT NL**

(71) Demandeur: **MATRA**
**4 rue de Presbourg**
**F-75116 Paris(FR)**

(72) Inventeur: **Lemoine, Maurice**
**131, Avenue de la Clairière**
**F-78120 Rambouillet(FR)**

(72) Inventeur: **Robbe, Michel**
**38 bis, rue du Maréchal Maunoury**
**F-78700 Conflans(FR)**

(72) Inventeur: **Gauvry, Olivier**
**4 bis, rue Gustave Zédé**
**F-75016 Paris(FR)**

(74) Mandataire: **Michardière, Bernard et al,**
**Cabinet Plasseraud 84, rue d'Amsterdam**
**F-75009 Paris(FR)**

(54) **Perfectionnements apportés aux filtres numériques et application de tels filtres numériques à la démodulation.**

(57) Filtre numérique propre à recevoir, sur une ligne d'entrée (e), des données $I_n$ qui se succèdent à intervalles de temps déterminés et qui comprend des moyens de multiplication (M) de chacune des $k$ dernières données par un coefficient $C_i$ associé ; des moyens d'addition (A) des résultats de chaque multiplication afin de fournir sur sa sortie, une grandeur de la forme $C_0.I_n + C_1.I_{n-1} ... + C_{n-k+1}.I_{n-k+1}$ ; des moyens de mémoire pour stocker $k$ coefficients déterminés et les $k$ dernières données ; et des moyens de séquence (2) pour l'adressage de ces moyens de mémoire de telle sorte que les coefficients et les données correspondantes soient fournis aux moyens de multiplication.

Les moyens de mémoire sont formés par une seule mémoire vive (RAM) (1) propre à stocker les $k$ coefficients déterminés et les $k$ dernières données introduits, par multiplexage, à l'entrée de la mémoire et les moyens de séquence (2) sont agencés de telle sorte, qu'en fin de cycle, la nouvelle donnée qui arrive sur la ligne d'entrée se substitue, dans la mémoire, à la donnée la plus ancienne.

Fig.1.

Perfectionnements apportés aux filtres numériques et application de tels filtres numériques à la démodulation.

L'invention est relative à des perfectionnements apportés aux filtres numériques du genre de ceux qui sont propres à recevoir, sur une ligne d'entrée, des données $l_n$ qui se succèdent à intervalles de temps déterminés et qui comprennent :

- des moyens de multiplication de chacune des $k$ dernières données par un coefficient $C_i$ associé ;

- des moyens d'addition des résultats de chaque multiplication afin de fournir sur sa sortie, une grandeur de la forme $C_0 \cdot l_n + C_1 \cdot l_{n-1} \cdots + C_{n-k+1} \cdot l_{n-k+1}$ ;

- des moyens de mémoire pour stocker $k$ coefficients déterminés et les $k$ dernières données ;

- et des moyens de séquence pour l'adressage de ces moyens de mémoire de telle sorte que les coefficients et les données correspondantes soient fournis aux moyens de multiplication.

Des filtres numériques de ce genre sont connus notamment d'après la DE-A n° 2 840 471 ou d'après ELECTRO 79 CONFERENCE RECORD PRESENTED AT ELECTRO 79, 24-26 avril 1979 NEW YORK (US) SESSION 8 : Advances in digital signal processing : hardware and techniques.M.J. NARASIMHA : "Implementation of F.I.R. filters with random access memories" 8/2 pages 1-5.

Toutefois, il est souhaitable de simplifier ces filtres numériques, notamment au niveau des moyens de mémoire ; il est en outre souhaitable de donner plus de souplesse à ces moyens de mémoire en vue de faciliter une modification éventuelle des valeurs de coefficients du filtre.

L'invention a pour but, surtout, de rendre les filtres numériques du genre en question tels qu'ils répondent mieux que jusqu'à présent aux diverses exigences de la pratique et notamment tels que leurs performances soient améliorées en ce qui concerne les points évoqués précédemment.

Selon l'invention, un filtre numérique du genre en question est caractérisé par le fait que les moyens de mémoire sont formés par une seule mémoire vive (RAM) propre à stocker les $k$ coefficients déterminés et les $k$

dernières données introduits, par multiplexage, à l'entrée de la mémoire et que les moyens de séquence sont agencés de telle sorte, qu'en fin de cycle, la nouvelle donnée qui arrive sur la ligne d'entrée se substitue, dans la mémoire, à la donnée la plus ancienne.

Deux compteurs sont associés, d'une manière connue en elle-même, respectivement aux coefficients et aux données, les sorties de ces compteurs étant reliées aux entrées d'adresse de la mémoire, le compteur des coefficients comportant une sortie branchée sur une entrée d'inhibition du compteur données, de telle sorte qu'en fin de cycle, le compteur des coefficients empêche l'incrémentation du compteur données, ce qui permet l'inscription, dans la mémoire, de la nouvelle donnée à la place de la donnée la plus ancienne et la circulation des données par rapport aux coefficients, le compteur des données se décalant d'un cran par rapport au compteur des coefficients ; les deux compteurs sont reliés aux entrées d'adresse de la mémoire par un multiplexeur.

Avantageusement, le compteur des coefficients et le compteur des données sont incrémentés, à partir des signaux provenant d'une horloge avec un décalage d'une demi-phase.

De préférence, la mémoire est propre à stocker 2$k$ coefficients et 2$k$ données, et l'ensemble est tel que pendant une première fraction d'un cycle, les $k$ premières données et les $k$ premiers coefficients stockés dans la mémoire sont utilisés pour fournir une première valeur de sortie, tandis que dans une deuxième fraction du cycle, les $k + 1$ à 2 $k$ coefficients suivants et $k + 1$ à 2 $k$ données suivantes sont utilisés pour établir une deuxième valeur de sortie, de telle sorte que deux filtres soient ainsi réalisés.

L'invention consiste, mises à part les dispositions exposées ci-dessus, en certaines autres dispositions dont il sera plus explicitement question ci-après, à propos d'un mode de réalisation décrit avec référence aux dessins ci-annexés, mais qui n'est nullement limitatif.

La fig. 1, de ces dessins, est un schéma synoptique simplifié d'un filtre numérique selon l'invention.

La fig. 2 est un schéma synoptique d'une partie des moyens de séquence.

La fig. 3 est un schéma illustrant une application du filtre selon l'invention.

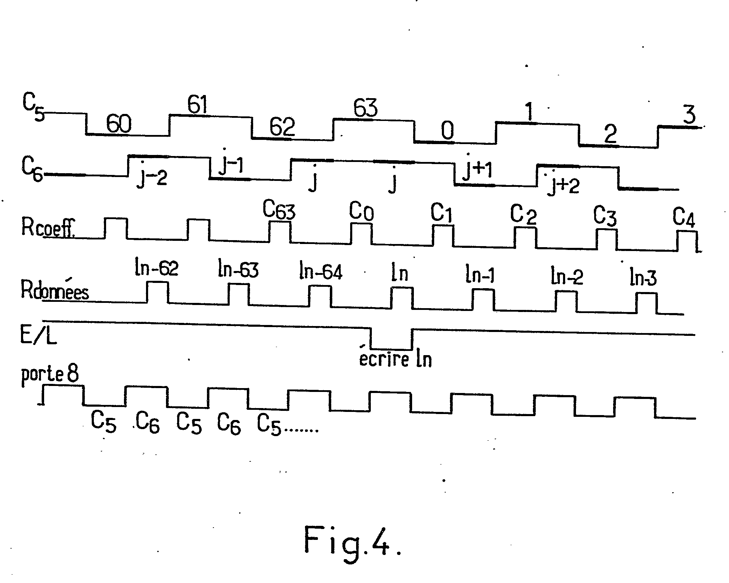

La fig. 4, enfin, est un diagramme de signaux et d'états intervenant dans la séquence.

En se reportant aux dessins, on peut voir un filtre numérique F qui reçoit, sur une ligne d'entrée $e$ des données $1_n$ qui se succèdent à intervalles de temps ou cycles $\Delta t$ déterminés. Le filtre F fournit sur une ligne de sortie s1 ou s2, une grandeur qui est égale à la somme d'une suite linéaire des $k$ dernières données, la grandeur de sortie s'exprimant sous la forme :

$$y = C_0 1_n + C_1 1_{n-1} + \cdots C_{n-k+1} \cdot 1_{n-k+1}.$$

Le filtre F comprend des moyens de multiplication M de chacune des $\underline{k}$ dernières données par un coefficient $c_i$ associé, et des moyens d'addition A des résultats de chaque multiplication.

Les données $l_n$ peuvent être fournies sous forme analogique et être converties sous forme numérique par un convertisseur analogique-digital B.

Le filtre F comporte une mémoire vive (RAM) 1 propre à stocker k coefficients déterminés $C_0$ ..... $C_{k-1}$, et les $\underline{k}$ dernières données $l_n$ ......$l_{n-k+1}$.

Cette mémoire 1 est adressée par des moyens de séquence 2 agencés de telle sorte que le temps mis pour le calcul d'au moins une grandeur de sortie ait une durée égale ou inférieure à l'intervalle de temps $\Delta t$ séparant deux données successives $l_j$, $l_{j+1}$ ; ladite mémoire fournit aux moyens de multiplication M les coefficients $C_i$ et les données $l_j$ correspondantes. Les moyens de multiplication M fournissent donc à leur sortie les produits $C_i \cdot l_j$ ; les moyens d'addition A établissent la somme des $\underline{k}$ produits pour fournir, sur au moins une sortie s1 ou s2, la grandeur corrigée $y = \Sigma\, C_i\, l_j$.

Cette grandeur $\underline{y}$, fournie par les moyens d'addition A, est dirigée vers la sortie $s_1$ ou $s_2$ par un interrupteur électronique I, schématiquement représenté, commandé par les moyens de séquence. Cet interrupteur I peut prendre une position intermédiaire isolant $s_1$ et $s_2$ de la sortie de A.

Les moyens de séquence 2 sont, en outre, agencés pour assurer le remplacement dans la mémoire, en fin de cycle, de la donnée la plus ancienne par exemple $l_{n-k+1}$ par la nouvelle donnée qui arrive sur la ligne $\underline{e}$, par exemple $l_{n+1}$.

Ce filtre numérique peut être utilisé comme périphérique d'un microprocesseur 3. Un circuit d'interface 4 est prévu pour la liaison avec le microprocesseur 3. Les coefficients $C_0$ ..... $C_{k-1}$ du filtre stockés dans la mémoire peuvent être sélectionnés par le microprocesseur 3 au début du traitement. Les données $l_n$ sont stockées dans la mémoire 1 au cours du traitement.

Les moyens de séquence 2 sont pilotés par le microprocesseur 3.

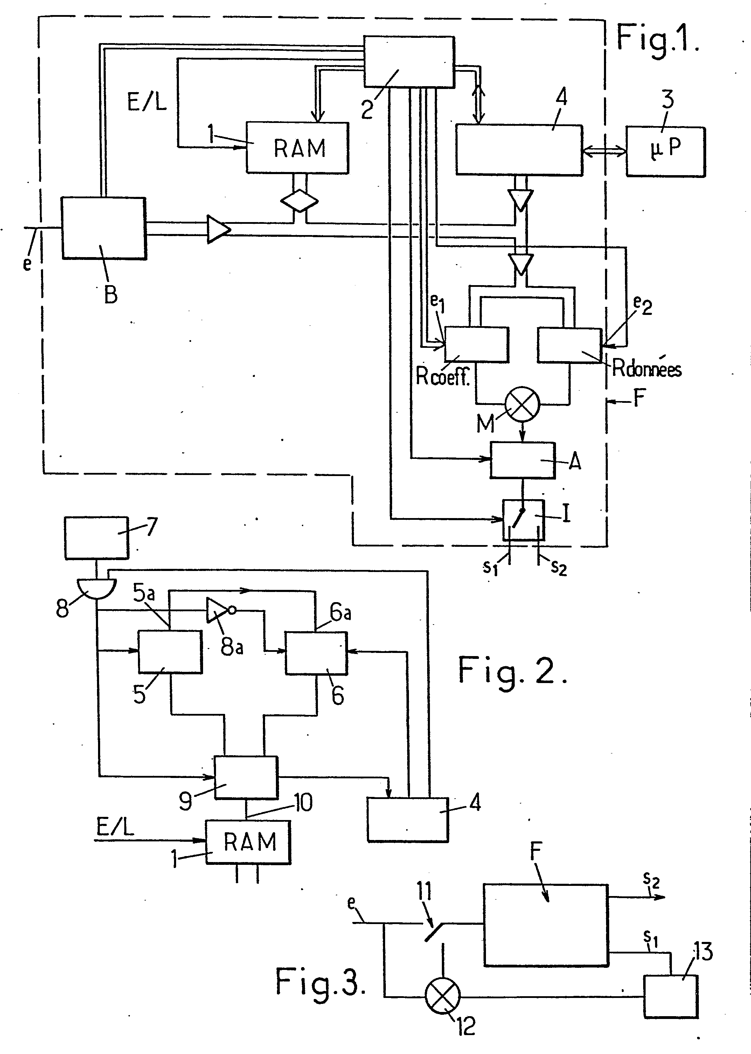

Ces moyens de séquence 2 comprennent avantageusement deux compteurs 5, 6 (fig. 2). Le compteur 5 est associé aux coefficients $C_0 \ldots C_{k-1}$, tandis que le compteur 6 est associé aux données $1_n$.

Le compteur 5 est incrémenté, au cours d'un cycle par les signaux provenant d'une horloge 7 par l'intermédiaire d'une porte ET 8 ; une entrée de cette porte ET est branchée à une sortie de l'horloge 7 tandis qu'une autre entrée de cette porte ET 8 est reliée à une sortie du circuit d'interface 4 qui intervient dans le pilotage des moyens de séquence.

La sortie de la porte ET 8 est reliée à une porte inverseuse 8a dont la sortie sert d'horloge au compteur 6 permettant ainsi un décalage d'une demi-phase entre les deux compteurs.

Une sortie 5a du compteur 5 associé aux coefficients est reliée à une entrée 6a d'inhibition du compteur 6. Lorsque le compteur 5 des coefficients arrive en fin de cycle, le signal présent sur la sortie 5a vient inhiber l'incrémentation du compteur 6 ; il en résulte que l'adresse affichée à la sortie du compteur 6 est maintenue sans changement, alors que l'adresse sur la sortie du compteur 5 augmente d'une unité.

Les sorties des compteurs 5 et 6 sont reliées à un multiplexeur 9. La sortie de ce multiplexeur est reliée aux entrées d'adresse 10 de la mémoire 1.

Les valeurs affichées à la sortie du compteur 5 correspondent aux adresses, dans la mémoire, des coefficients $C_i$. A chaque coup d'horloge, l'adresse affichée à la sortie du compteur 5 progresse d'une unité.

Les adresses fournies à la sortie du compteur 6 correspondent à celles des données stockées dans la mémoire 1.

Pour préciser les explications, des exemples numériques sont fournis ci-après, mais ces exemples ne sont en aucun cas limitatifs.

La mémoire 1 peut être une mémoire à 128 mots de huit bits. Cette mémoire comporte dont 128 cases que l'on peut considérer numérotées de 0 à 127.

Ces cases sont divisées en deux zones : 0 à 63 et 64 à 127, de 64 cases chacune.

Dans les cases de la zone 0 à 63 sont inscrits les coefficients $C_0 \ldots\ldots C_{k-1}$, tandis que dans les cases de la zone 64 à 127 sont inscrites les données $l_n$.

Dans cet exemple numérique, on a donc $k = 64$.

Les compteurs 5 et 6 qui assurent l'adressage de la mémoire 1 peuvent être des compteurs à sept bits.

Les nombres 0, 1... 63 sur la sortie du compteur 5 correspondent aux adresses des cases 0 à 63 de la mémoire 1.

Les nombres 0 à 63 sur la sortie du compteur 6 correspondent aux adresses des cases 64 à 127 de la mémoire 1.

Le fonctionnement est le suivant.

Les moyens de séquence 2, qui sont initialisés par l'interface 4, gèrent l'adressage de la mémoire 1 ainsi que l'utilisation des moyens de multiplication M.

Un cycle complet dont la durée correspond à l'intervalle $\Delta t$ entre deux données successives $l_n$, $l_{n+1}$ sur la ligne e, comporte 64 phases pour l'élaboration de la grandeur de sortie.

A la ième phase du n ième cycle, il convient d'extraire de la mémoire 1 le coefficient $C_i$ et la valeur $l_{n-i}$ qui correspond à la donnée présentée au début du i ième cycle précédent.

Les coefficients $C_0$, $C_1 \ldots\ldots C_{63}$ sont chargés respectivement aux adresses 63, 0..... 61, 62 de la mémoire 1.

Soit j la valeur affichée par le compteur 6 à sa sortie lorsque le compteur 5 affiche 62 sur sa sortie, à la fin du (n − 1) ième cycle.

Au coup d'horloge suivant, la sortie du compteur 5 passe à la valeur 63 ; du fait de la liaison 5a, 6a, évoquée précédemment, l'incrémentation du compteur 6 est inhibée et la valeur d'adresse $\underline{j}$ est maintenue à la sortie du compteur 6.

Pendant la phase suivante, c'est-à-dire pendant la phase correspondant à la valeur 63 présente sur la sortie du compteur 5, la donnée $1_n$ qui arrive sur la ligne $\underline{e}$ est écrite dans la mémoire 1 à l'adresse $\underline{j}$ en remplacement, dans cette case, de la donnée la plus ancienne $1_{n-64}$.

Cette nouvelle donnée $1_n$ est envoyée simultanément dans l'opérande du circuit multiplieur M ; le coefficient qui lui est associé est celui correspondant à la case 63 de la mémoire 1, c'est-à-dire $C_0$.

Le circuit multiplieur M fournira donc à sa sortie, le produit $C_0 \cdot 1_n$ en ce début du n ième cycle.

A la fin de ce n ième cycle, le compteur 5 va afficher sur sa sortie, après 64 incrémentations, le nombre 63 ; parallèlement, le compteur 6 ne s'est incrémenté que 63 fois de telle sorte que l'adresse qui sera affichée par le compteur 6 sur sa sortie, en fin de ce n ième cycle, sera $j - 1$.

La donnée suivante $1_{n+1}$ sera donc écrite dans la case de la mémoire 1 dont l'adresse est $j - 1$.

Au coup d'horloge suivant, le compteur 5 passe à 0 et le compteur 6 s'incrémente à nouveau et affiche sur sa sortie, la valeur d'adresse $j$. La donnée stockée dans la case $\underline{j}$ de la mémoire 1, c'est-à-dire la valeur $1_n$, est alors extraite et associée au coefficient $C_1$ pour le traitement du cycle n + 1.

A la fin du (n + 63)ème cycle, lorsque la sortie du compteur 5 est égale à 62, l'adresse pointés par le compteur 6 est égale à $j - 64$ module (64) = $j$ ; par suite à la valeur $1_n$ pointée par le compteur 6 est associée $C_{63}$. De même, pendant le cycle, à $1_{n+1}$ pointée par $j - 1$, est associée $C_{62}$ et à $1_{n+63}$ correspond $C_0$ ; la valeur obtenue en fin de cycle est donc :

$$Y_{n + 63} = \sum_{k = 0}^{k = 63} C_k 1_{n + 63 - k}.$$

Cette relation est vraie pour tout $\underline{n}$ de telle sorte que l'on obtient bien, à la sortie du filtre F, une grandeur de la forme $C_0 . 1_n + C_1 . 1_{n - 1} + \ldots$

En se reportant à la fig. 5, on peut voir, représentés sur plusieurs lignes, divers signaux ou états intervenant dans la séquence; le temps est porté en abscisses et la tension est portée en ordonnées.

La première ligne désignée par la référence $C_5$ représente les états successifs du dernier étage du compteur 5, correspondant au bit de moindre poids.

La deuxième ligne, désignée par C6, représente de manière semblable , les états successifs du dernier étage du compteur 6.

La troisième ligne R coeff. représente les signaux d'horloge attaquant l'entrée el d'un registre coefficients R coeff. (voir fig. 1) relié au multiplieur M.

La quatrième ligne R données représente les signaux d'horloge attaquant l'entrée e2 d'un registre données R données (voir fig. 1) relié au multiplieur M.

La cinquième ligne représente les signaux envoyés sur l'entrée E/L d'écriture/lecture de la mémoire 1.

La sixième ligne représente les signaux d'horloge à la sortie de la porte 8.

On voit que, comme expliqué précédemment, le compteur 6 est décalé d'une demi-phase par rapport au compteur 5. L'incrémentation a lieu, par exemple, sur le front descendant des signaux d'horloge provenant de la porte 8 pour le compteur 5. En raison de la porte inverseuse 8a, le compteur 6 sera attaqué par un front descendant, provoquant son incrémentation, avec un décalage d'une demi-phase par rapport aux signaux à la sortie de la porte 8.

Les signaux d'horloge de la porte 8 valident à l'état bas, l'adressage présenté par le compteur 5, tandis, qu'à l'état haut, ils valident l'adressage présenté par le compteur 6.

Les parties validées des adressages des compteurs ont été représentées sur les deux premières lignes par des traits renforcés.

A l'état haut de l'horloge R coeff, les valeurs présentées sur le bus données de la mémoire 1 sont écrites dans le registre R coeff., pour l'opérande X de la multiplication. Cet état apparaît toujours sur un état bas de la porte 8. L'adresse validée est donc celle du compteur 5.

A l'état haut de l'horloge R donnée, les valeurs présentées sur le bus données de la mémoire 1 sont écrites dans le registre R données (fig. 1) pour l'opérande Y de la multiplication. L'adresse validée est celle du compteur 6 et la donnée correspondante est extraite de la mémoire 1.

La multiplication X Y est alors effectué par le multiplieur M et le résultat est envoyé dans l'additionneur A pour être ajouté aux résultats précédents.

Tous les 64 cycles de la porte 8, la valeur présentée sur le bus donnée de la mémoire 1 est celle de la donnée présentée par le convertisseur B.

Dans la représentation de la fig. 5, les états successifs du compteur 5 ont été numérotés de 0 à 63 en considérant que l'état 0 correspond au début d'un cycle (arrivée d'une donnée $1_{n-1}$ fournie par le convertisseur B), tandis que l'état 63 correspond à la fin du cycle et précède immédiatement l'arrivée de la donnée suivante $1_n$ fournie par le convertisseur B.

Chaque état du compteur 5 correspond à un cycle de la porte 8.

Comme expliqué précédemment, le compteur 5, en arrivant à l'état 63 empêche l'incrémentation du compteur données 6. Comme visible à la deuxième ligne de la figure 5, l'état j du compteur 6 est donc maintenu pendant deux cycles de la porte 8, lorsque l'état 63 apparaît sur le compteur 5.

Le signal d'écriture (ligne E/L de la fig. 5) dans la mémoire 1 est envoyé à un instant tel que la donnée $1_n$, fournie par le convertisseur B, soit inscrite à l'adresse $\underline{j}$, fournie par le compteur 6, à la place de la donnée la plus ancienne $1_{n-64}$.

En même temps se produit la circulation des données par rapport aux coefficients, le compteur 6 se décalant d'un cran par rapport au compteur 5.

En début de traitement, pour le chargement des coefficients dans la mémoire 1, on utilise le même principe en attribuant au compteur C 6 la fonction adressage de la partie de la mémoire qui correspond aux coefficients. A chaque cycle on inscrit en fin de cycle un coefficient notamment présenté par le microprocesseur, dans une case de la mémoire. Le décalage d'un cran, introduit par le maintien du dernier état sur la sortie du compteur C 6, permet d'inscrire le coefficient suivant qui se présente dans une case suivante de la mémoire. A la fin de l'inscription de tous les coefficients (après un nombre de cycles égal à celui des coefficients), on réattribue au compteur C 6 sa fonction d'adressage des données et au compteur C 5 sa fonction d'adressage des coefficients.

Dans l'exemple décrit précédemment, le filtre F fournit, pour chaque intervalle de temps $\Delta t$ entre deux données successives $1_n$, $1_{n+1}$ une seule grandeur de sortie.

Avantageusement, la mémoire 1 est propre à stocker 2 $\underline{k}$ coefficients et 2 $\underline{k}$ données et l'ensemble est tel que pendant une première fraction d'un cycle, les $\underline{k}$ premières données et les $\underline{k}$ premiers coefficients stockés dans la mémoire sont utilisés pour fournir une première valeur de sortie, par exemple sur la sortie $s_1$, tandis que dans une deuxième fraction du cycle, les $k + 1$ à 2 $\underline{k}$ coefficients suivants et $k + 1$ à 2 $\underline{k}$ données suivantes, sont utilisés pour établir une deuxième valeur de sortie, de telle sorte que le filtre F jour le rôle de deux filtres à caractéristiques différentes.

11  **0046121**

A titre d'exemple numérique, non limitatif, on peut utiliser la même mémoire 1 à 128 mots de huit bits.

Les cases seront toujours divisées en deux zones de 0 à 63 et de 64 à 127, chaque zone comportant 64 cases.

On considère, maintenant, que $k_- = 32$ ; on stocke, dans les 32 première cases de la zone 0-63, c'est-à-dire dans les cases 0 à 31 de la mémoire, les coefficients $C_0 \ldots \ldots C_{31}$ correspondant à un premier filtre.

Dans la première moitié de la zone 64 à 127, c'est-à-dire dans les 32 cases numérotées 64 à 95, sont stockées les 32 données qui seront associées aux coefficients précédents.

Dans la deuxième moitié de la zone des coefficients, c'est-à-dire dans les cases numérotées 32 à 63 seront stockées 32 autres valeurs de coefficients $C_{32}$ à $C_{63}$ ; ces coefficients seront ceux utilisés pour réaliser le deuxième filtre.

Dans la deuxième partie de la zone 64 à 127, c'est-à-dire dans les cases numérotées 96 à 127 seront stockées 32 données qui peuvent être différentes ou identiques aux données stockées dans les cases 64 à 95.

La grandeur de sortie élaborée avec les coefficients $C_0$ à $C_{31}$, et les données correspondantes, sera fournie par exemple sur la sortie $s_1$, tandis que la grandeur de sortie élaborée avec les autres coefficients $C_{32}$ à $C_{63}$, et les données correspondantes, sera fournie sur la sortie $s_2$.

D'une manière plus générale, on peut prévoir une mémoire 1 propre à stocker mk coefficients et mk données; les moyens de séquence 2 sont agencés pour découper l'intervalle de temps $\Delta t$ séparant deux données successives $l_n$, $l_{n+1}$ en $\underline{m}$ fractions de cycle et pour que dans chaque fraction du cycle soit calculée une grandeur de sortie à partir d'un groupe de coefficients et du groupe correspondant de données. Le filtre F remplacerait ainsi $\underline{m}$ filtres de caractéristiques différentes.

12

Chaque fraction de cycle correspond à un traitement ; m traitements sont ainsi assurés à chaque cycle.

A la fin de chaque traitement, on effectue une compression de la donnée la plus ancienne par écriture de la nouvelle donnée, sans toutefois provoquer un décalage entre données et coefficients. Ce n'est qu'à la fin du $m^e$ traitement du cycle, c'est-à-dire en fin de cycle, que l'on assure un décalage d'un cran du compteur données par rapport au compteur coefficients.

Une application particulièrement intéressante d'un filtre F qui agit comme deux filtres à caractéristiques différentes concerne la démodulation à la réception de signaux sur une fréquence porteuse.

Comme montré sur la figure 3, on prévoit à l'entrée du filtre F un commutateur 11 propre à sélectionner, au cours d'un cycle complet de traitement, d'abord la ligne e, puis le résultat de la multiplication de la porteuse par le signal de ligne. Cette multiplication est effectuée dans un multiplieur analogique 12.

La fréquence porteuse est récupérée par un filtrage passe-bande autour de celle-ci, sur la sortie $s_1$. Dans l'exemple numérique évoqué précédemment, avec une mémoire de 128 mots, les coefficients appropriés $C_0$ à $C_{31}$ seraient stockés dans les cases 0 à 31.

La sortie $s_1$ est reliée à une entrée du multiplieur analogique 12 par l'intermédiaire d'un filtre passe-bas analogique 13 pour supprimer les repliements autour des harmoniques de la fréquence d'échantillonnage.

Sur l'autre sortie $s_2$ du filtre F, on obtient le signal démodulé obtenu par filtrage passe-bas et égalisation du résultat de la multiplication analogique dans 12. Toujours dans l'exemple numérique évoqué précédemment, les coefficients $C_{32}$ à $C_{63}$ de ce filtre passe-bas seraient stockés dans les cases 32 à 63 de la mémoire 1 tandis que les données correspondantes seraient stockées dans les cases 96 à 127. La fréquence porteuse est récupérée avec un déphasage constant et faible.

**0046121**

Le filtre de l'invention peut également être utilisé pour la modulation d'amplitude, notamment en bande latérale résiduelle (BLR), le filtre servant à une mise en forme appropriée.

D'une manière générale, tout filtrage peut être effectué avec le filtre de l'invention, qui n'introduit pas de distorsion de phase.

Un tel filtre convient particulièrement au domaine de la télécopie pour la transmission et la réception des informations.

REVENDICATIONS

1. Filtre numérique propre à recevoir, sur une ligne d'entrée, des données $l_n$ qui se succèdent à intervalles de temps déterminés et qui comprend :

- des moyens de multiplication de chacune des $\underline{k}$ dernières données par un coefficient $C_i$ associé ;

- des moyens d'addition des résultats de chaque multiplication afin de fournir sur sa sortie, une grandeur de la forme $C_0 \cdot l_n + C_1 \cdot l_{n-1} \cdots + C_{n-k+1} \cdot l_{n-k+1}$ ;

- des moyens de mémoire pour stocker $\underline{k}$ coefficients déterminés et les $\underline{k}$ dernières données ;

- et des moyens de séquence pour l'adressage de ces moyens de mémoire de telle sorte que les coefficients et les données correspondantes soient fournis aux moyens de multiplication,

caractérisé par le fait que les moyens de mémoire sont formés par une seule mémoire vive (RAM) (1) propre à stocker les $\underline{k}$ coefficients déterminés et les $\underline{k}$ dernières données introduits, par multiplexage, à l'entrée de la mémoire et que les moyens de séquence (2) sont agencés de telle sorte , qu'en fin de cycle, la nouvelle donnée qui arrive sur la ligne d'entrée se substitue, dans la mémoire, à la donnée la plus ancienne.

2. Filtre selon la revendication 1, caractérisé par le fait que les moyens de séquence (2) comprennent, d'une manière connue en elle-même, deux compteurs (5,6) associés respectivement aux coefficients et aux données, les sorties de ces compteurs étant reliées aux entrées d'adresse de la mémoire (1), le compteur (5) des coefficients comportant une sortie (5a) branchée sur une entrée (6a) d'inhibition du compteur données (6), de telle sorte qu'en fin de cycle, le compteur des coefficients empêche l'incrémentation du compteur données, ce qui permet l'inscription, dans la mémoire (1), de la nouvelle donnée à la place de la donnée la plus ancienne et la circulation des données par rapport aux coefficients, le compteur des données se décalant d'un cran par rapport au compteur des coefficients, et que les compteurs (5, 6) sont reliés aux entrées d'a-

dresse de la mémoire (1) par un multiplexeur (9).

3. Filtre selon la revendication 2, caractérisé par le fait que le compteur des coefficients (5) et le compteur des données (6) sont incrémentés, à partir des signaux provenant d'une horloge (7) avec un décalage d'une demi-phase.

4. Filtre selon la revendication 3, caractérisé par le fait qu'une porte inverseuse (8a) branchée sur le compteur des données (6) permet d'établir le décalage d'une demi-phase par rapport au compteur des coefficients.

5. Filtre selon l'une quelconque des revendications précédentes, caractérisé par le fait que la mémoire (1) est propre à stocker $2\ k$ coefficients et $2\ k$ données, l'ensemble étant tel que, pendant une première fraction d'un cycle, les $k$ premières données et les $k$ premiers coefficients stockés dans la mémoire sont utilisés pour fournir une première valeur de sortie, tandis que dans une deuxième fraction du cycle, les $k + 1$ à $2\ k$ coefficients suivants et $k + 1$ à $2\ k$ données suivantes sont utilisées pour établir une deuxième valeur de sortie, de telle sorte que deux filtres soient ainsi réalisés.

6. Filtre selon la revendication 5, caractérisé par le fait qu'il comporte un interrupteur électronique (I), commandé par les moyens de séquence (2) propre à diriger vers une première sortie (s1) ou une deuxième sortie (s2) les valeurs provenant des deux filtres.

7. Filtre selon la revendication 4, caractérisé par le fait que la mémoire (1) est propre à stocker $m\ k$ coefficients et $m\ k$ données, les moyens de séquence étant agencés pour découper l'intervalle de temps ($\Delta t$) séparant deux données successives en $m$ fractions de cycles et pour que, dans chaque fraction du cycle, soit calculée une grandeur de sortie à partir d'un groupe de coefficients et du groupe correspondant de données, le filtre remplaçant ainsi $m$ filtres de caractéristiques différentes.

8. Application d'un filtre selon l'une quelconque des revendications précédentes à la démodulation lors de la réception de signaux sur une fréquence porteuse, notamment pour la télécopie.

9. Application, selon la revendication 8 , d'un filtre selon la revendication 5, caractérisé par le fait qu'on prévoit, à l'entrée du filtre (F) un commutateur (11) propre à sélectionner, au cours d'un cycle complet de traitement, d'abord la ligne (e) puis le résultat de la multiplication de la porteuse par le signal de ligne, cette multiplication étant effectuée dans un multiplieur analogique (12), la première sortie (s1) du filtre (F) étant reliée à l'entrée du multiplieur analogique (12) par l'intermédiaire d'un filtre passe-bas analogique (13), tandis que sur l'autre sortie (s2) du filtre (F) on obtient le signal démodulé.

0046121

Fig.1.

Fig. 2.

Fig.3.

Fig.4.